(19) Europäisches Patentamt
European Patent Office
Office européen des brevets

(11) **EP 4 691 783 A1**

(12) **EUROPEAN PATENT APPLICATION**


(43) Date of publication:
**11.02.2026 Bulletin 2026/07**

(21) Application number: **25193968.2**

(22) Date of filing: **05.08.2025**

(51) International Patent Classification (IPC):
***B41J 2/16*** *(2006.01)*

(52) Cooperative Patent Classification (CPC):
**B41J 2/164; B41J 2/1606; B41J 2/1645;**
B41J 2202/03

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.08.2024 JP 2024130179**
**02.05.2025 JP 2025076586**



(71) Applicant: **CANON KABUSHIKI KAISHA**
**Ohta-ku**
**Tokyo 146-8501 (JP)**

(72) Inventors:
- **HAMADE, Yohei**
  **Tokyo, 146-8501 (JP)**
- **TSUTSUI, Satoshi**
  **Tokyo, 146-8501 (JP)**
- **YAMAJI, Haruka**
  **Tokyo, 146-8501 (JP)**
- **KOBATAKE, Erika**
  **Tokyo, 146-8501 (JP)**
- **ISHII, Miho**
  **Tokyo, 146-8501 (JP)**
- **TAKAI, Yu**
  **Tokyo, 146-8501 (JP)**

(74) Representative: **TBK**
**Bavariaring 4-6**
**80336 München (DE)**


(54) **PHOTOSENSITIVE RESIN COMPOSITION, LIQUID-REPELLENT ANTI-FOULING FILM, AND INKJET RECORDING HEAD**


(57) An inkjet recording head that has a liquid-repellent anti-fouling film (7) on a surface in which a discharge port (5) is disposed, wherein the liquid-repellent anti-fouling film (7) is a cured product of a photosensitive resin composition, and the photosensitive resin composition comprises: an alkylsiloxane-comprising resin (A) with specific structure; an alkylsiloxane-comprising resin (B) with specific structure; and a photopolymerization initiator, wherein a molar ratio A : B between the alkylsiloxane-comprising resin (A) and the alkylsiloxane-comprising resin (B) is from 3 : 1 to 1 : 3.


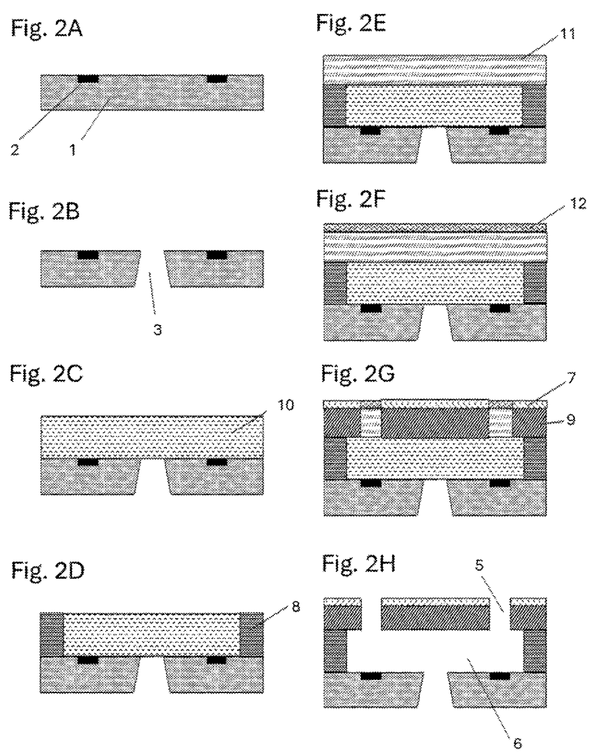


EP 4 691 783 A1

## Description

### TECHNICAL FIELD

The present disclosure relates to a photosensitive resin composition, a liquid-repellent anti-fouling film, and an inkjet recording head.

### BACKGROUND

Fluorine-based water-repellent materials are generally known as materials that form liquid-repellent anti-fouling films, and in particular compounds bearing perfluoroalkyl groups or perfluoropolyether groups exhibit an excellent liquid repellency and an excellent durability and are thus widely used in a variety of applications. However, since fluorine-comprising compounds exhibit a high chemical stability and are resistant to degradation, if they are continuously discharged into the environment they may remain present in the environment on a long-term basis and can, by moving through the environment and food chain, affect human health and the habitat and growth of animals and plants. As a consequence, in order to realize a sustainable society such as a recycling-oriented society, there has been a desire in recent years for a switch from fluorine-based water-repellent materials to non-fluorine-based water-repellent materials.

Silicone compounds are water-repellent materials that do not comprise fluorine, but which still exhibit an excellent liquid repellency and can thus be used as an alternative to fluorine-based water-repellent materials. Silicone compounds can eliminate, inter alia, concerns with environmental impact and concerns with regard to fluorine sources.

For example, Japanese Patent Laid-open No. 2001-158818 discloses a technology that uses a silicone compound, and particularly a siloxane-comprising epoxy resin composition, as a non-fluorine-based water-repellent material. With the composition described in Japanese Patent Laid-open No. 2001-158818, the epoxy group forms a crosslinked structure during curing and not only liquid repellency, but also mechanical

### SUMMARY

As in Japanese Patent Laid-open No. 2001-158818, when the silicone compound has a functional group at only one terminal of the siloxane main chain, the siloxane main chain then readily undergoes orientation at the surface and a high liquid repellency can be realized. However, according to investigations by the present inventors, the mechanical strength may be inadequate since a configuration is present in which only one terminal of the siloxane main chain is anchored in the cured product.

On the other hand, when a silicone compound is used that has a functional group at both terminals, a strong anchoring is generated in the cured product and in addition the flexibility or elasticity of the siloxane main chain can be improved and a high mechanical strength can be obtained. However, due, in this case, to a reduction in the orientation of the siloxane main chain at the surface, the liquid repellency may be reduced and the persistence of the liquid repellency may also be impaired.

The present disclosure provides a photosensitive resin composition comprising a silicone compound that can realize both a high liquid repellency and a high mechanical strength. The present disclosure also provides a liquid-repellent anti-fouling film and inkjet recording head using the above photosensitive resin composition.

The present disclosure in its first aspect provides an inkjet recording head as specified in claim 1. Optional features are specified in claim 2 to 12.

Features of the present disclosure will become apparent from the following description of embodiments with reference to the attached drawings. The following description of embodiments is described by way of example.

The present disclosure provides a photosensitive resin composition comprising a silicone compound that can realize both a high liquid repellency and a high mechanical strength. The present disclosure also provides a liquid-repellent anti-fouling film and inkjet recording head using the above photosensitive resin composition.

### BRIEF DESCRIPTION OF THE DRAWINGS

FIGS. 1A and 1B are schematic diagrams of an inkjet recording head that employs a liquid-repellent anti-fouling film;
FIGS. 2A to 2H are diagrams for describing an example of a method for producing an inkjet recording head that uses a liquid-repellent anti-fouling film; and
FIGS. 3A and 3B are diagrams for describing a procedure for forming a liquid-repellent anti-fouling film.

DESCRIPTION OF THE EMBODIMENTS

In the present disclosure, the expression of "from XX to YY" or "XX to YY" indicating a numerical range means a numerical range including a lower limit and an upper limit which are end points, unless otherwise specified. Also, when a numerical range is described in a stepwise manner, the upper and lower limits of each numerical range can be arbitrarily combined. In addition, in the present disclosure, for example, descriptions such as "at least one selected from the group consisting of XX, YY and ZZ" mean any of XX, YY, ZZ, the combination of XX and YY, the combination of XX and ZZ, the combination of YY and ZZ, and the combination of XX, YY, and ZZ. If XX is a group, it is permissible to select multiple items from XX, and the same applies to YY and ZZ.

Embodiments of the present disclosure are provided and described in the following; however, the present disclosure is not limited to only these embodiments, nor is everything of a combination of features described in the present embodiments necessarily essential to the solution provided by the present disclosure. The components described in the embodiments are merely examples and there is no intent or purport to limit the scope of the present disclosure to only these.

The components for obtaining the photosensitive resin composition according to the present disclosure are described in the following.

The Alkylsiloxane Resin

In order to achieve both a high liquid repellency and a high mechanical strength, the photosensitive resin composition has an alkylsiloxane-comprising resin (A) and an alkylsiloxane-comprising resin (B) at a molar ratio between the alkylsiloxane-comprising resin (A) and alkylsiloxane-comprising resin (B) (alkylsiloxane-comprising resin (A) : alkylsiloxane-comprising resin (B) (also referred to simply as "A : B")) of from 3 : 1 to 1 : 3.

The alkylsiloxane-comprising resin (A) has an epoxy-comprising group for one of either of $R_4$ and $X_1$ in a silicone molecule represented by following formula (1).

The alkylsiloxane-comprising resin (B) has an epoxy-comprising group for at least two of $R_7$, $R_8$, $X_3$ and $X_4$ in the silicone molecule represented by following formula (2).

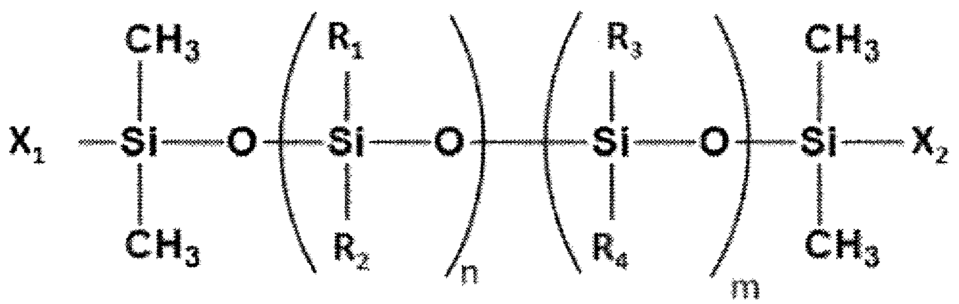

(1)

In formula (1), $R_1$, $R_2$, $R_3$, and $X_2$ are each independently an alkyl group with carbon numbers of 1 to 12 or an aryl group with carbon numbers of 6 to 12; one of either of $R_4$ and $X_1$ is an alkyl group with carbon numbers of 1 to 12 or an aryl group with carbon numbers of 6 to 12 and other one is an epoxy-comprising group; and n + m is an integer from 1 to 60.

The sequence of the structure of parentheses marked with m and the sequence of the structure of parentheses marked with n may be random or block.

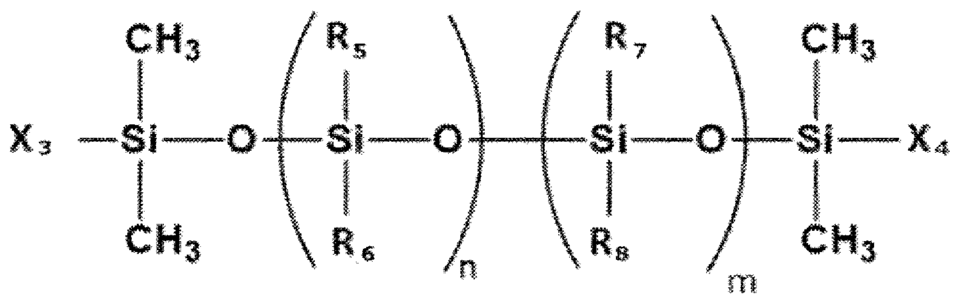

(2)

In formula (2), $R_5$ and $R_6$ are each independently an alkyl group with carbon numbers of 1 to 12 or an aryl group with carbon numbers of 6 to 12; at least two of $R_7$, $R_8$, $X_3$ and $X_4$ are each independently an epoxy-comprising group, and others are each independently an alkyl group with carbon numbers of 1 to 12 or an aryl group with carbon numbers of 6 to

12; and n + m is an integer from 1 to 60. The sequence of a structure of parentheses marked with m and the sequence of the structure of parentheses marked with n may be random or block.

The epoxy-comprising group can be exemplified by groups that have a glycidyl ether group and groups that have an alicyclic epoxy group. The epoxy-comprising group is preferably a group having a glycidyl ether group or a group having an epoxycyclohexyl group.

The epoxy-comprising group is more preferably a glycidoxyalkyl group in which the alkyl chain has 1 to 4 (preferably 2 to 4) carbons or an epoxycyclohexylalkyl group in which the alkyl chain has 1 to 8 (preferably 2 to 6) carbons. The epoxy-comprising group is still more preferably a 3-glycidoxyalkyl group in which the alkyl chain has 1 to 4 (preferably 2 to 4) carbons or a 2-(3,4-epoxycyclohexyl)alkyl group in which the alkyl chain has 1 to 8 (preferably 2 to 6) carbons.

The epoxy-comprising group is more preferably a 3-glycidoxypropyl group, 2-(3,4-epoxycyclohexyl)ethyl group, or 2-(3,4-epoxycyclohexyl)pentyl group. An epoxycyclohexylalkyl group in particular makes it possible to obtain an excellent reactivity and a high liquid repellency.

At a high proportion for the siloxane resin (A), the orientation of the siloxane main chain is improved and a high water repellency is obtained. At a high proportion for the siloxane resin (B), on the other hand, a strong anchoring in the film occurs and as a consequence an excellent durability can be obtained and the water repellency can be maintained on a long-term basis. Thus, it becomes possible to obtain both a high liquid repellency and a high mechanical strength by mixing these two siloxane resins at a molar ratio (A : B) of from 3 : 1 to 1 : 3. The A : B molar ratio is preferably from 2 : 1 to 1 : 2. The resin (A) may be a single species or a plurality of species may be used. The resin (B) may be a single species or a plurality of species may be used.

The alkyl group with carbon numbers of 1 to 12 in formulas (1) and (2) is particularly preferably an alkyl group with carbon numbers of 1 to 4, e.g., the methyl group, ethyl group, propyl group, and butyl group. From the standpoints of compatibility with resins and the film strength, for example, a phenyl group may be present in formulas (1) and (2) as the aryl group with carbon numbers of 6 to 12.

$X_1$ in formula (1) is preferably an epoxy-comprising group from the standpoints of achieving a high liquid repellency and a high mechanical strength to an even greater degree.

Preferably two of the $R_7$, $R_8$, $X_3$, and $X_4$ in formula (2) are an epoxy-comprising group. Preferably $X_3$ and $X_4$ are an epoxy-comprising group and $R_7$ and $R_8$ are each independently an alkyl group with carbon numbers of 1 to 12 or an aryl group with carbon numbers of 6 to 12.

From the standpoints of compatibility with resins and solubility in solvents, m + n in formulas (1) and (2) is from 1 to 60 and preferably from 10 to 60. m + n is more preferably from 30 to 60 from the standpoint of the liquid repellency. m + n in formula (2) is preferably from 20 to 60 and more preferably from 25 to 45.

The m in formulas (1) and (2) is preferably 0 or 1. In addition, a sequence of a structure of parentheses marked with m and a sequence of a structure of parentheses marked with n may be random or block. Preferably the sequence of the structure of parentheses marked with m and the sequence of the structure of parentheses marked with n is random.

The total content of the alkylsiloxane-comprising resin (A) represented by formula (1) and alkylsiloxane-comprising resin (B) represented by formula (2) in the photosensitive resin composition is preferably from 0.1 to 50.0 mass% and more preferably from 0.5 to 40.0 mass%.

When the photosensitive resin composition comprises an epoxy resin, the total content of the alkylsiloxane-comprising resin (A) represented by formula (1) and alkylsiloxane-comprising resin (B) represented by formula (2) is preferably from 0.1 to 5.0 mass% and more preferably from 0.5 to 1.0 mass%. In addition, the total content of the alkylsiloxane-comprising resin (A) represented by formula (1) and alkylsiloxane-comprising resin (B) represented by formula (2), per 100 mass parts of the epoxy resin, is preferably from 0.1 to 5.0 mass parts and more preferably from 0.5 to 1.0 mass parts.

## The Epoxy Resin

The photosensitive resin composition may also comprise an epoxy resin. The epoxy resin is preferably a cationic polymerizable epoxy resin and can be selected considering the adhesive performance, mechanical strength, and swelling resistance of the cured product from the photosensitive resin composition. The epoxy resin, for example, is a resin different from the hereinabove-described alkylsiloxane-comprising resin (A) with formula (1) and the alkylsiloxane-comprising resin (B) with formula (2).

The epoxy resin (B) is preferably at least one selected from the group consisting of epoxy resin having an alicyclic skeleton, epoxy resin having a bisphenol skeleton, epoxy resin having a phenol novolac skeleton, epoxy resin having a cresol novolac skeleton, epoxy resin having a norbornene skeleton, epoxy resin having a terpene skeleton, epoxy resin having a dicyclopentadiene skeleton, epoxy resin having an oxycyclohexane skeleton.

More specifically, examples are cationic polymerizable epoxy resins, e.g., polyfunctional epoxy resins, for example, epoxy resins having an alicyclic skeleton such as a cyclohexane skeleton, epoxy resins having a bisphenol skeleton such as bisphenol A epoxy resins and bisphenol F epoxy resins, epoxy resins having a phenol novolac skeleton

such as phenol novolac epoxy resins, epoxy resins having a cresol novolac skeleton such as cresol novolac epoxy resins, epoxy resins having a norbornene skeleton, epoxy resins having a terpene skeleton, epoxy resins having a dicyclopentadiene skeleton, and epoxy resins having an oxycyclohexane skeleton. A single one of these may be used or a combination of two or more may be used.

The epoxy resin is more preferably at least one selected from the group consisting of epoxy resins having an alicyclic skeleton, epoxy resins having a bisphenol skeleton, and epoxy resins having a dicyclopentadiene skeleton.

By using an epoxy resin with two or more functional epoxy groups, the cured product undergoes three-dimensional crosslinking and a desirable curability can be obtained. It is more preferable to use an epoxy resin having three or more functional epoxy groups. Furthermore, it is also possible to use at least one kind of difunctional epoxy resin in addition to the three or more functional epoxy resin.

Commercially available three or more functional epoxy resins can be exemplified by "jER157S70" and "jER1031S" (product names) from the Mitsubishi Chemical Corporation; "Epiclon N-695" and "Epiclon N-865" (product names) from the DIC Corporation; "Celloxide 2021", "GT-300 series", "GT-400 series", and "EHPE3150" (product names) from the Daicel Corporation; "SU8" (product name) from Nippon Kayaku Co., Ltd.; "VG3101" (product name) and "EPOX-MKR1710" (product name) from the Printec Corporation; and "Denacol series" from the Nagase ChemteX Corporation.

Commercially available difunctional epoxy resins can be exemplified by "jER1004", "jER1007", "jER1009", "jER1010", and "jER1256" (product names) from the Mitsubishi Chemical Corporation, and "Epiclon 7200L", "Epiclon 4050", and "Epiclon 7050" (product names) from the DIC Corporation.

The epoxy resin content in the photosensitive resin composition is preferably from 30.0 to 99.0 mass%, more preferably from 50.0 to 99.0 mass%, and still more preferably from 85.0 to 99.0 mass%.

Cure Accelerator

The photosensitive resin composition may comprise a phenolic compound or a polyol having at least 2 hydroxyl groups as a cure accelerator. The addition of these results in acceleration of the cationic polymerization reaction of the epoxy resins.

Specific examples of the above mentioned phenolic compounds include cardanol, terpene diphenol, and derivatives thereof. Examples are cardanol compounds such as cardanol and cardanol derivatives. Cardanol derivatives can be exemplified by derivatives in which the -OH of cardanol has been epoxy-modified. Commercially available products include "Cardolite NX-2026", "Cardolite NC-510", "Cardolite LITE 2020", and "Cardolite Ultra LITE 513" from the Cardolite Corporation.

When the polyol has one hydroxyl group, there is little effect with regard to promoting the cationic polymerization reaction of the epoxy resins, and as a consequence the polyol preferably has two or more hydroxyl groups. In addition, from the standpoints of the solubility in resins and solvents and the reactivity, the polyol preferably has a number-average molecular weight of 3000 or less. In addition, in order to not disappear during a heating step, the polyol preferably has a number-average molecular weight of 200 or more, or a boiling point of 200°C or more. The number-average molecular weight can be calculated as polystyrene by a known method using gel permeation chromatography (for example, from the Shimadzu Corporation).

The polyol can be specifically exemplified by polyethylene glycols (200, 300, 400, 600, 1000, 2000), which are commercially available from various companies. In addition, polyether polyols can be exemplified by the "ADEKA POLYETHER P series", "BPX series", "G series", "SP series", "SC series", "CM series", "AM series", "EM series", "BM series", "PR series", and "GR series" (all product names) from the ADEKA Corporation.

The polyol may be a low-molecular-weight polyhydric alcohol. Low-molecular-weight polyhydric alcohols can be exemplified by 1,2- or 1,6-hexanediol, glycerol, trimethylolpropane, 3-methyl-1,5-pentanediol, 1,2,6-hexanetriol, 1,5-dihydroxypentan-3-one, 6-hydroxycaproic acid, and 2-hydroxymethyl-1,3-propanediol. One or more of these can be used.

Coating Solvents

When the photosensitive resin composition is to be applied in the form of a solution as a coating, a polar organic solvent is preferably used as the coating solvent from a solubility standpoint. Specific examples here are polar solvents, e.g., alcohols; ketones; esters such as ethyl acetate, butyl acetate, and propylene glycol monomethyl ether acetate (PGMEA); ethers such as diglyme, tetrahydrofuran, and PGME; and glycols such as diethylene glycol. The alcohols can be exemplified by methanol, ethanol, propanol, isopropanol, and butanol, and the ketones can be exemplified by methyl ethyl ketone and methyl isobutyl ketone.

Photopolymerization Initiator

The photosensitive resin composition comprises a photopolymerization initiator. When the photosensitive resin composition is coated onto a substrate and cured, due to the presence of the photopolymerization initiator a liquid-repellent anti-fouling film can be formed by generating a cured product through exposure to light. In this case, the liquid repellency and mechanical strength are substantially improved in comparison to thermal curing and microfine processing by patterning is also made possible.

Cationic photopolymerization initiators, which enable low-temperature curing and exhibit a high catalytic performance, can be advantageously used as the photopolymerization initiator. Ionic acid generators can be selected as a specific cationic photopolymerization initiator. The photopolymerization initiator is preferably an ionic acid generator.

A high absorbance onium type can be selected as the cation moiety of the ionic acid generator, and an onium ion, e.g., oxonium, ammonium, phosphonium, sulfonium, iodonium, and so forth, can be selected. Among these, sulfonium, which has a high i-line (wavelength of 365 nm) absorbance and exhibits an excellent cationic polymerization performance and an excellent crosslinking reactivity, is more preferred.

The cation in the ionic acid generator is preferably a sulfonium ion.

The following are specific examples of sulfonium-type cationic ions:

triarylsulfoniums such as triphenylsulfonium, tri-p-tolylsulfonium, tri-o-tolylsulfonium, tris(4-methoxyphenyl)sulfonium, 1-naphthyldiphenylsulfonium, 2-naphthyldiphenylsulfonium, tris(4-fluorophenyl)sulfonium, tri-1-naphthylsulfonium, tri-2-naphthylsulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium, [4-(2-thioxanthonylthio)phenyl]diphenylsulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl} sulfide, bis{4-[bis(4-methylphenyl)sulfonio]phenyl} sulfide, bis{4-[bis(4-methoxyphenyl)sulfonio]phenyl} sulfide, 4-(4-benzoyl-2-chlorophenylthio)phenylbis(4-fluorophenyl)sulfonium, 4-(4-benzoyl-2-chlorophenylthio)phenyldiphenyl sulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-ylphenylsulfonium, 4-[4-(4-tert-butylbenzoyl)phenylthio]phenyldi-p-tolylsulfonium, 4-[4-(4-tert-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thianthrenium, 5-phenylthianthrenium, 5-tolylthianthrenium, 5-(4-ethoxyphenyl)thianthrenium, and 5-(2,4,6-trimethylphenyl)thianthrenium;

diarylsulfoniums such as diphenylphenacylsulfonium, diphenyl-4-nitrophenacylsulfonium, diphenylbenzylsulfonium, and diphenylmethylsulfonium;

monoarylsulfoniums such as phenylmethylbenzylsulfonium, 4-hydroxyphenylmethylbenzylsulfonium, 4-methoxyphenylmethylbenzylsulfonium, 4-acetocarbonyloxyphenylmethylbenzylsulfonium, 4-hydroxyphenylmethyl-1-naphthylmethylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacylsulfonium, 4-hydroxyphenylmethylphenacylsulfonium, 4-methoxyphenylmethylphenacylsulfonium, 4-acetocarbonyloxyphenylmethylphenacylsulfonium, 2-naphthylmethylphenacylsulfonium, 2-naphthyloctadecylphenacylsulfonium, and 9-anthracenylmethylphenacylsulfonium; and trialkylsulfoniums such as dimethylphenacylsulfonium, phenacyltetrahydrothiophenium, dimethylbenzylsulfonium, benzyltetrahydrothiophenium, and octadecylmethylphenacylsulfonium.

The molar extinction coefficient of the photopolymerization initiator at a wavelength of 365 nm is preferably 400 $M^{-1} \cdot cm^{-1}$ or more. By having the molar extinction coefficient be 400 $M^{-1} \cdot cm^{-1}$ or more, the photopatternability can be improved while achieving additional improvements in the liquid repellency without reducing the crosslink density during the curing reaction.

Measurement of the molar extinction coefficient of a compound, e.g., the photopolymerization initiator, is carried out as follows.

A solution is prepared by dissolving a target compound in a solvent that does not absorb at 365 nm, for example, acetonitrile. The resulting solution is introduced into a quartz cell and the absorbance at 365 nm is measured using a UV-Vis-Infrared spectrophotometer (JASCO Corporation). The molar extinction coefficient can be calculated from the obtained absorbance using the following formula.

Molar extinction coefficient = absorbance ÷ molar concentration of the compound ÷ optical path length of the cell

For example, a high-acid-strength borate type or phosphorus type, antimony type, or gallate type can be selected for the anion moiety of the ionic acid generator.

Among these, the tetrakis(pentafluorophenyl)borate ion, trifluorotris(pentafluoroethyl)phosphate ion, hexafluoroantimonate ion, and tetrakis(pentafluorophenyl)gallate ion, which exhibit an excellent cationic polymerization performance and an excellent crosslinking reactivity, are more preferred. The use of these makes it possible to improve the photo pattern ability while achieving additional improvements in the liquid repellency.

The anion in the ionic acid generator is preferably at least one selected from the group consisting of the tetrakis(pentafluorophenyl)borate ion, trifluorotris(pentafluoroethyl)phosphate ion, hexafluoroantimonate ion, and tetrakis(pentafluorophenyl)gallate ion.

The following are examples of photopolymerization initiators that can be favorably used: "ADEKA Optomer SP-170", "ADEKA ARKLS SP-172", and "ADEKA ARKLS SP-150" (all product names) from the ADEKA Corporation, and "BBI-103" and "BBI-102" (all product names) from Midori Kagaku Co., Ltd. Other examples are "IBPF", "IBCF", "TS-01", and "TS-91" (all product names) from Sanwa Chemical Co., Ltd., and "CPI-410S", "CR-C1", "CPI-410B", "CPI-310B", and "CPI-310FG" (all product names) from San-Apro Ltd.

In addition, the instant composition may comprise, for example, basic substances such as amines, photosensitizers such as anthracene derivatives, and silane coupling agents, for the purpose of improving, inter alia, the photolithographic performance and adhesion performance.

The content of the photopolymerization initiator can be varied as appropriate in correspondence to the resin being used and is not particularly limited. The amount of addition of the photopolymerization initiator, per 100 mass parts of the resin present in the photosensitive resin composition, is, for example, in the range from 0.5 to 200 mass parts and preferably in the range from 0.5 to 5 mass parts.

## Substrate

The substrate for forming the liquid-repellent anti-fouling film is not particularly limited and can be selected primarily from inorganic substrates and resin compositions.

Inorganic substrates can be exemplified by Si, $SiO_2$, SiOC, SiC, SiCN, Ta, TaO, $Al_2O_3$, and so forth.

Negative-type epoxy resin compositions in which the main component is a polyfunctional epoxy resin are used for the resin composition. Specific examples are bisphenol A epoxy resins, bisphenol E epoxy resins, bisphenol F epoxy resins, novolac epoxy resins, cresol novolac epoxy resins, alicyclic epoxy resins, and so forth.

Commercially available epoxy resins can be exemplified by "157S70" and "jER1031S" (product names) from the Mitsubishi Chemical Corporation, and "Epiclon N-695" and "Epiclon N-865" (product names) from the DIC Corporation. Other examples are "Celloxide 2021", "GT-300 series", "GT-400 series", and "EHPE3150" (product names) from the Daicel Corporation, and "SU8" (product name) from Nippon Kayaku Co., Ltd. Additional examples are "VG3101" and "EPOX-MKR1710" (product names) from the Printec Corporation, and "Denacol series" (product name) from the Nagase ChemteX Corporation.

As an example of the application of the liquid-repellent anti-fouling film, a method for producing an inkjet recording head is described in the following with reference to the drawings. The range of applications of the liquid-repellent anti-fouling film according to the present disclosure is not limited to this.

## Method for Producing a Recording Head

FIG. 1A is a schematic diagram that gives an example of an inkjet recording head, and FIG. 1B is a cross-sectional diagram in which this recording head is visualized in a cross section perpendicular to the substrate 1 along A - B in FIG. 1A.

The recording head depicted in FIGS. 1A and 1B has a substrate 1 in which energy-generating elements 2, which generate energy employed to discharge a liquid, are arranged at a prescribed pitch in two rows side by side. A liquid supply port 3 is opened in the substrate 1 between the two rows of the energy-generating elements 2. Discharge ports 5 are formed on the substrate 1 by a discharge port-forming member 4 and are disposed at positions facing each of the energy-generating elements 2.

The shape of the discharge port 5 may be a so-called tapered shape whereby the area of the cross section parallel to the substrate 1 decreases from the substrate 1 side toward the discharge port 5. The discharge port-forming member 4 is composed of: a side wall 8 that forms individual flow paths 6 that communicate from the supply port 3 to each discharge port 5; and a top plate 9 in which the discharge ports 5 open. The side wall 8 and the top plate 9 in the discharge port-forming member 4 may be integrated into a single body.

A liquid-repellent anti-fouling film (liquid-repellent layer) 7 is provided on the discharge port-forming member. For example, the inkjet recording head may have the liquid-repellent anti-fouling film 7 on the surface in which the discharge

ports are disposed. The liquid-repellent anti-fouling film 7 suppresses adhesion of the ink discharged from the discharge ports 5 to the surface of the recording head. The shape, material, and so forth of the substrate 1 are not particularly limited as long as the substrate 1 can function as a part of the member constituting the flow path 6 and can function as a support for the discharge port-forming member 4. In the present embodiment, a silicon substrate is used for the substrate 1 based on ease of processing.

This recording head is disposed such that the recording surface of the recording medium is faced by the recording head surface in which the discharge ports 5 open. Recording is carried out as follows: energy generated by an energy-generating element 2 is imparted to the ink filled in a flow path 6 via the supply port 3, causing ink droplets to be discharged from a discharge port 5 and adhere to the recording medium. The following, for example, can be used for the energy-generating element 2: for example, an electrothermal conversion element (a so-called heater) as an element that generates energy by heating; or, for example, a piezoelectric element as an element that generates energy mechanically.

The liquid-repellent anti-fouling film 7 is a cured product from the photosensitive resin composition. In specific terms, the liquid-repellent anti-fouling film 7 can be formed by the coating application of a solution comprising the photosensitive resin composition and by curing the coating film of this solution to form a liquid-repellent anti-fouling film that is the cured product.

An example of a method for producing an inkjet recording head is described in the following with reference to FIGS. 2A to 2H. Except for the liquid-repellent anti-fouling film 7, known components can be used in the inkjet recording head.

FIGS. 2A to 2H are schematic cross-sectional diagrams that show, in accordance with the steps involved, an example of a method for producing an inkjet recording head, and the position of the cross section is the same as in FIG. 1B.

First, as shown in FIG. 2A, a substrate 1 having energy-generating elements 2 provided in its surface is prepared. An electrode (not shown) for inputting a control signal for operating an energy-generating element 2 is connected to the element. Various functional layers may also be provided, e.g., a protective layer (not shown) for improving the durability of an energy-generating element 2 and an adhesion-improving layer (not shown) for improving the adhesion between the discharge port-forming member 4 and the substrate 1.

As shown in FIG. 2B, an ink supply port 3 is then formed that passes through the substrate 1. The supply port 3 can be formed by wet etching using an alkaline etching solution such as tetramethylammonium hydroxide (TMAH) or by dry etching such as reactive ion etching.

As shown in FIG. 2C, a first photosensitive resin layer 10 comprising a photosensitive resin and a photopolymerization initiator is then formed on the substrate 1 that comprises the energy-generating elements 2. The first photosensitive resin layer 10 is a so-called negative-type photosensitive resin layer. The first photosensitive resin layer 10 preferably is formed by coating a photosensitive resin on a film substrate made of PET or polyimide and transferring onto the substrate 1 using a lamination method. An epoxy resin can be advantageously used for the photosensitive resin present in the first photosensitive resin layer 10 because this satisfies various performance requirements, e.g., high mechanical strength, adhesion to the underlayer, ink resistance, and resolution for patterning the fine pattern of the discharge ports 5.

The same epoxy resin and photopolymerization initiator as described above can be used for the epoxy resin and photopolymerization initiator here.

The amount of addition of the photopolymerization initiator can be any amount of addition that achieves a target sensitivity. The amount of addition of the photopolymerization initiator is preferably in the range 0.5 to 5 mass% relative to the epoxy resin. A wavelength sensitizer may be added as necessary. An example of such a wavelength sensitizer is "SP-100" (product name) from the ADEKA Corporation.

Additives may be added as necessary and appropriate to the hereinabove-described photosensitive resin composition. For example, a flexibility-imparting agent may be added with the goal of lowering the elastic modulus of the epoxy resin, or a silane coupling agent may be added in order to obtain greater adhesive strength with the underlayer.

As shown in FIG. 2D, a side wall 8 is then formed by patternwise exposure through a mask (not shown) followed by a heat treatment. The mask comprises a light-blocking film, e.g., a chromium film, formed, in conformity to the pattern of the flow paths 6, on a substrate composed of a material, e.g., glass or quartz, that transmits light at the exposure wavelength. The following can be used as the exposure device: a projection exposure device having a single-wavelength light source, e.g., an i-line exposure stepper or a KrF stepper, or having a mercury lamp broad-wavelength light source, e.g., a "Mask Aligner MPA-600 Super" (product name) from Canon, Inc.

As shown in FIG. 2E, a second photosensitive resin layer 11 is formed on the substrate 1 on which the side walls 8 have thusly been formed. The second photosensitive resin layer 11 is a negative-type photosensitive resin layer like the first photosensitive resin layer 10. A bisphenol epoxy resin or a novolac epoxy resin is preferably used as the photosensitive resin comprised in the second photosensitive resin layer 11. The second photosensitive resin layer 11 can be formed by a method like that for the first photosensitive resin layer 10.

As shown in FIG. 2F, there is then formed, on the second photosensitive resin layer 11, a coating film 12 of a solution of the photosensitive resin composition for forming the hereinabove-described liquid-repellent anti-fouling film 7.

The coating film 12 can be formed by coating this photosensitive resin composition using a method such as spin coating, roll coating, slit coating, and so forth.

As shown in FIG. 2G, the top plate 9 and the liquid-repellent anti-fouling film 7 are then formed by patternwise exposure through a mask (not shown) followed by curing. The mask comprises a light-blocking film, e.g., a chromium film, formed in conformity to the pattern of the discharge ports 5 on a substrate composed of a material, e.g., glass or quartz, that transmits light at the exposure wavelength. The following can be used as the exposure device: a projection exposure device having a single-wavelength light source, e.g., an i-line exposure stepper or a KrF stepper, or having a mercury lamp broad-wavelength light source, e.g., a "Mask Aligner MPA-600 Super" (product name) from Canon, Inc.

As shown in FIG. 2H, the unexposed portions of the second photosensitive resin layer 11 and the coating film 12 are then removed by a development process to form the discharge ports 5. By exposing and developing both the second photosensitive resin layer 11 and the coating film 12 at the same time, the cationic polymerizable groups in the second photosensitive resin layer 11 and the coating film 12 can react with each other to yield a highly durable liquid-repellent anti-fouling film 7 having strong antistatic properties. The unexposed portions of the first photosensitive resin layer 10 are also dissolved and removed at the same time to form the flow paths 6.

A heat treatment is also performed as necessary, and members for supplying ink (not shown) are connected and electrical connections (not shown) for driving the energy-generating elements 2 are made in order to complete the inkjet recording head.

Recording Method

Using the hereinabove-described inkjet recording head, the recording method according to an embodiment of the present disclosure records an image on a recording medium by the discharge of a liquid, and particularly a pigment-comprising ink, from the inkjet recording head.

When this inkjet recording head is filled with ink, the side surface of the liquid-repellent anti-fouling film is always in contact with the ink. By using this inkjet recording head, discharge failures can be suppressed even during use on a long-term basis because the liquid-repellent anti-fouling film 7 exhibits ink durability.

Examples

The present disclosure is described in additional detail by providing the following examples; however, the present disclosure is not limited to or by the following examples.

Formation of Liquid-Repellent Anti-Fouling Films

Example 1

A liquid-repellent anti-fouling film was formed using the procedures of FIGS. 3A and 3B. The photosensitive resin composition 1 given in Table 5-1 was coated on a silicon substrate 13 to form a coating film 12 and a heat treatment was carried out for 3 minutes at 70°C. The coating film 12 was then exposed at 5,000 J $m^{-2}$ using an i-line exposure stepper ("FPA-3000i5+", Canon, Inc.) and a heat treatment was carried out for 5 minutes at 90°C. After washing using PGMEA, an additional heat treatment was carried out for 1 hour at 200°C to form a liquid-repellent anti-fouling film 7.

The formulation for the photosensitive resin composition 1 is as follows.

a epoxy resin : 100 mass parts
d photopolymerization initiator: 1.5 mass parts
h resin (A) : 0.4 mass parts
n resin (B) : 0.4 mass parts
solvent PGMEA : to bring the solids concentration to 20 mass%

The materials a to v used in the photosensitive resin compositions in the individual examples and comparative examples, including those described below, are indicated in Tables 4-1, 4-2, 4-3, and 4-4.

Examples 2 to 118

Liquid-repellent anti-fouling films were fabricated proceeding as in Example 1, but using the photosensitive resin compositions 2 to 135 indicated in Tables 5-1, 5-2 and 5-3 for formation of the liquid-repellent anti-fouling film 7.

In the examples that used a cure accelerator, the cure accelerator was used at 3 mass% relative to the epoxy resin.

In the examples that did not use an epoxy resin, the photosensitive resin compositions were obtained using the following blending amounts.

photopolymerization initiator : 1.5 mass parts
resin (A) : 0.4 mass parts
resin (B) : 0.4 mass parts
solvent PGMEA : to bring the solids concentration to 20 mass%

Comparative Examples 1 to 8

Liquid-repellent anti-fouling films were fabricated proceeding as in Example 1, but using the photosensitive resin compositions 136 to 143 indicated in Table 6 for formation of the liquid-repellent anti-fouling film 7.

Fabrication of Inkjet Recording Heads

Separately from the liquid-repellent anti-fouling film, an inkjet recording head was fabricated by the steps shown in FIGS. 2A to 2H.

As shown in FIG. 2A, a substrate 1 having energy-generating elements 2 provided in its surface was first prepared, and, as shown in FIG. 2B, an ink supply port 3 that passes through the substrate 1 was formed by etching using TMAH.

As shown in FIG. 2C, a first photosensitive resin layer 10 was then formed by transferring, by a lamination method, the cationic polymerizable resin composition shown in Table 1 onto the substrate 1 comprising the energy-generating elements 2. As shown in FIG. 2D, a side wall 8 was formed by carrying out patternwise exposure via a mask (not shown) composed of quartz and by carrying out a heat treatment for 5 minutes at 90°C. An i-line exposure stepper ("FPA-3000i5+", Canon, Inc.) was used for the exposure device, and 10,000 J $m^{-2}$ was used for the exposure dose.

As shown in FIG. 2E, a second photosensitive resin layer 11 was formed on the substrate 1 on which the side wall 8 had been thusly formed. The second photosensitive resin layer 11 was transferred by a lamination method using the cationic polymerizable resin composition indicated in Table 2.

As shown in FIG. 2F, the photosensitive resin composition with the formulation of Example 1 shown in Table 5-1 was coated on the second photosensitive resin layer 11 and a heat treatment was carried out for 3 minutes at 70°C. A patternwise exposure, via a mask (not shown) bearing a pattern for the discharge ports 5, was carried out at the same time for both the second photosensitive resin layer 11 and the coating film 12, and a heat treatment was carried out for 5 minutes at 90°C. An i-line exposure stepper ("FPA-3000i5+", Canon, Inc.) was used for the exposure device, and 5,000 J $m^{-2}$ was used for the exposure dose (FIG. 2G).

Finally, the unexposed portions of the photosensitive resin layer and coating film were dissolved and removed using PGMEA and a heat treatment was carried out for 1 hour at 200°C to form the discharge ports 5, flow paths 6, and liquid-repellent anti-fouling film 7 (FIG. 2H).

[Table 1]

| | | |
|---|---|---|
| Epoxy resin | Product name : EPICLON N-695, manufactured by DIC Corporation | 100 mass parts |
| Photopolymerization initiator | Product name : ADEKA ARKLS SP-172, manufactured by ADEKA Corporation | 6 mass parts |
| Solvent | Product name : OMR Thinner, manufactured by Tokyo Ohka Kogyo Co., Ltd. | 70 mass parts |

[Table 2]

| | | |
|---|---|---|
| Epoxy resin | Product name : 157S70, manufactured by Mitsubishi Chemical Corp. | 100 mass parts |
| Photopolymerization initiator | Product name : CPI-410S, manufactured by San-Apro Ltd. | 0.01 mass parts |
| Solvent | Product name : PGMEA, manufactured by Kishida Chemical Co., Ltd. | 20 mass parts |

Examples 2 to 135

The inkjet recording heads of Examples 2 to 135 were fabricated proceeding as in Example 1, but respectively changing the coating solution used to form the liquid-repellent anti-fouling film 7 in the fabrication of the inkjet recording head according to Example 1, to the photosensitive resin compositions 2 to 135 indicated in Tables 5-1, 5-2 and 5-3.

Comparative Examples 1 to 8

The inkjet recording heads of Comparative Examples 1 to 8 were fabricated proceeding as in Example 1, but respectively changing the coating solution used to form the liquid-repellent anti-fouling film 7 in the fabrication of the inkjet recording head according to Example 1, to the photosensitive resin compositions 136 to 143 indicated in Table 6.

Evaluation of the Liquid-Repellent Anti-Fouling Films

The following evaluations were carried out on the liquid-repellent anti-fouling films fabricated according to the methods of Examples 1 to 135 and Comparative Examples 1 to 8.

Initial Water Repellency

Using a micro-contact angle meter ("DropMeasure" (product name) from the Microjet Corporation), the initial water repellency was evaluated by measuring the dynamic receding contact angle $\theta\gamma$ of the liquid-repellent anti-fouling film versus pure water. An evaluation of A was assigned when the water repellency was excellent with $\theta\gamma$ of 85° or more; an evaluation of B was assigned when $\theta\gamma$ was 70° or more and less than 85°, where use as a liquid-repellent anti-fouling film is possible; and an evaluation of C was assigned when $\theta\gamma$ was less than 70°, in which the water repellency was insufficient for a liquid-repellent anti-fouling film.

Ink Durability

The liquid-repellent anti-fouling film was held for 1 week at 70°C while immersed in a pigment-comprising ink. $\theta\gamma$ was then measured as described above and the ink durability was evaluated. An evaluation of A was assigned when $\theta\gamma$ was 85° or more; an evaluation of B was assigned when the repellency was 70° or more and less than 85°; and an evaluation of C was assigned when $\theta\gamma$ was less than 70°, in which the water repellency was insufficient for a liquid-repellent anti-fouling film.

Wiping Durability

The liquid-repellent anti-fouling film was wiped using a pigment ink and using the conditions given in Table 3. The mechanical strength was then evaluated by measuring $\theta\gamma$ as described above using a micro-contact angle meter ("DropMeasure" (product name) from the Microjet Corporation).

An evaluation of A was assigned when $\theta\gamma$ was 85° or more; an evaluation of B was assigned when the repellency was 70° or more and less than 85°; and an evaluation of C was assigned when $\theta\gamma$ was less than 70°, in which the water repellency was insufficient for a liquid-repellent anti-fouling film.

[Table 3]

| | | |
|---|---|---|
| Wiping member | Material | HNBR |
| | Thickness | 0.65mm |
| Wiping conditions | Free length | 3.0mm |
| | Intrusion amount | 0.5mm |
| | Wiping velocity | 100mm/sec |
| | Number of wipes | 2000 times |

The results of these evaluations are given in Tables 5-1, 5-2 and 5-3and Table 6. In the tables, n-Bu indicates the n-butyl group and Me indicates the methyl group.

Evaluation of Inkjet Recording Heads

The inkjet recording heads fabricated in Examples 1 to 135 and Comparative Examples 1 to 8 were evaluated as follows.

Each of the inkjet recording heads to be evaluated was swapped into an MB5330 printer from Canon, Inc., and a continuous printing test was carried out in a 30°C/80% RH environment and the presence/absence of dot distortion was visually checked. 100 sheets of A4 solid text were continuously printed in the continuous printing test. With regard to print distortion, the print quality was scored as NG if distortion was produced at even one location in an A4 print.

[Table 4-1]

| No. | Compound |
|---|---|
| a | jER1004F (Mitsubishi Chemical Corporation) |
| b | 157870 (Mitsubishi Chemical Corporation) |
| c | EPICLON HP-7200L (DIC Corporation) |
| d | EHPE3150 (Daicel Corporation) |
| e | CPI-410S (San-Apro Ltd.) molar extinction coefficient : 9600$M^{-1} \cdot cm^{-1}$ 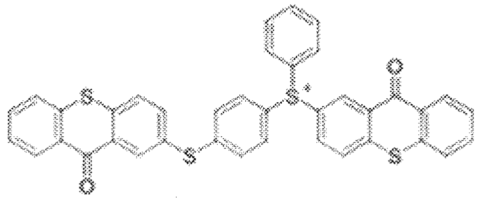 $PF_3(C_2F_5)_3^-$ |
| f | ES-1B (San-Apro Ltd.) molar extinction coefficient : 960O$M^{-1} \cdot cm^{-1}$ 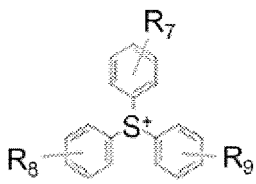 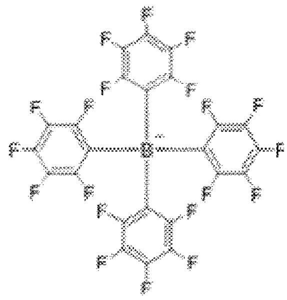 |
| g | CPI-310B (San-Apro Ltd.) molar extinction coefficient : 600$M^{-1} \cdot cm^{-1}$ 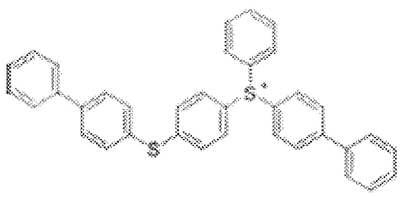 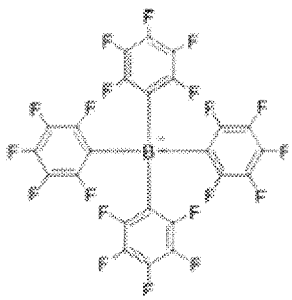 |

(continued)

| No. | Compound |
|---|---|
| h | CPI-410B (San-Apro Ltd.) molar extinction coefficient : 9600$M^{-1} \cdot cm^{-1}$ 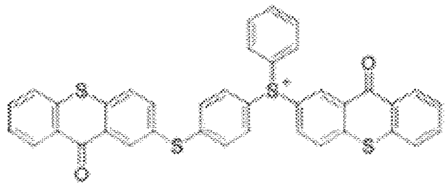 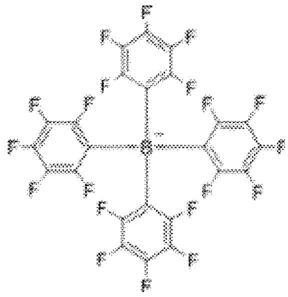 |
| i | CPI-101A (San-Apro Ltd.) molar extinction coefficient : 80$M^{-1} \cdot cm^{-1}$ 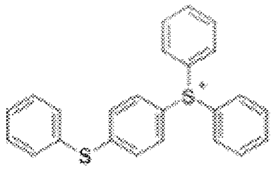 $SbF_6^-$ |

[Table 4-2]

| No. | Compound |
|---|---|
| j | SP-172 (ADEKA Corporation) molar extinction coefficient : 450$M^{-1} \cdot cm^{-1}$ 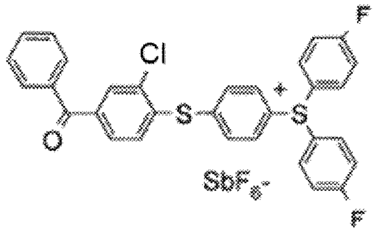 |
| k | CPI-310FG (San-Apro Ltd.) molar extinction coefficient : 600$M^{-1} \cdot cm^{-1}$ 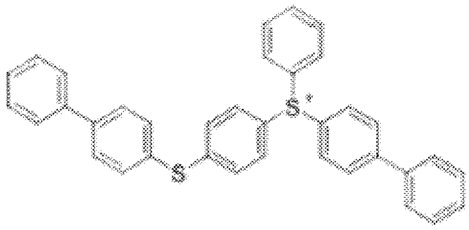 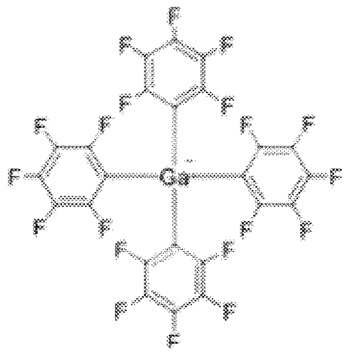 |

(continued)

| No. | Compound |
|---|---|
| l | VC-1FG (San-Apro Ltd.) molar extinction coefficient : 12000$M^{-1} \cdot cm^{-1}$ 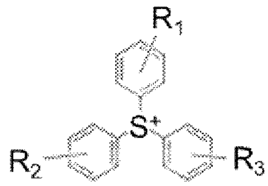 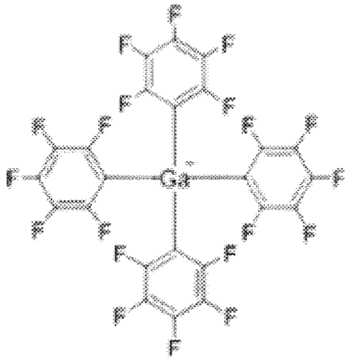 |
| m | CPI-110P (San-Apro Ltd.) molar extinction coefficient : 80$M^{-1} \cdot cm^{-1}$ 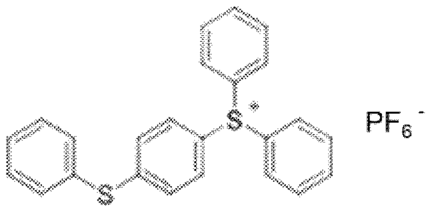 |
| m | PEG600 (Kishida Chemical Co., Ltd.) |
| n | NX-2026 (Cardolite Corporation) |
| o | UltraLite513 (Cardolite Corporation) |

[Table 4-3]

| No. | Compound | |
|---|---|---|
| p | 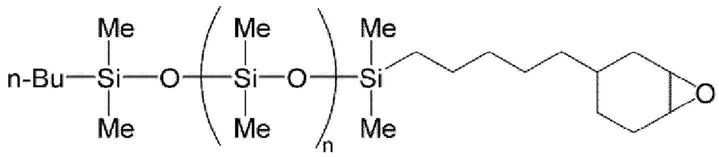 | ※ n=30 |
| q | 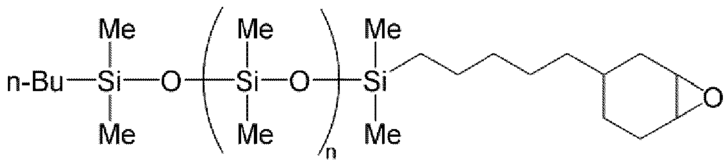 | ※ n=10 |
| r | 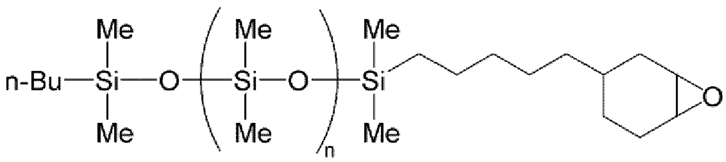 | ※ n=60 |
| s | 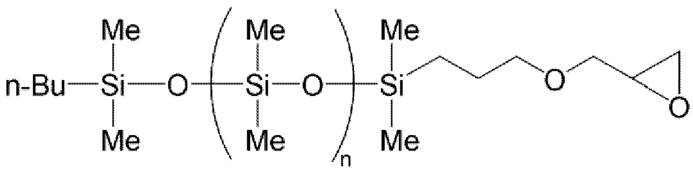 | ※ n=30 |

(continued)

| No. | Compound | |
|---|---|---|
| t | 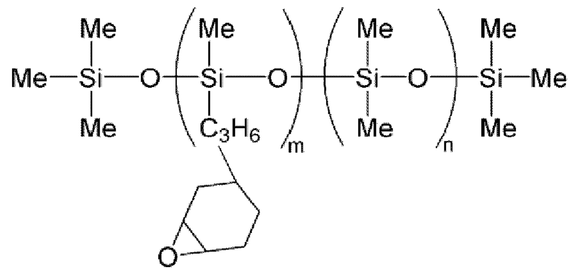 | ※ m=1 n=30 |
| u | 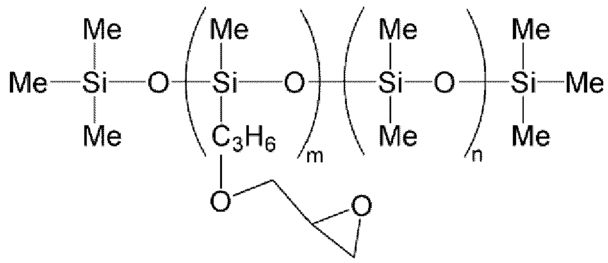 | ※ m=1<br>n=30 |
| v | 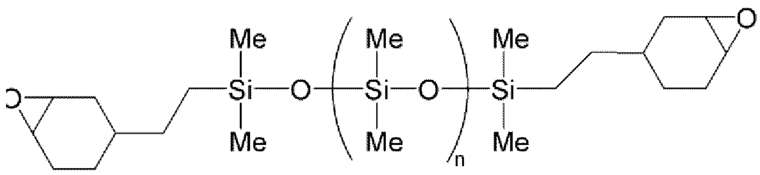 | ※ n=41 |
| w | 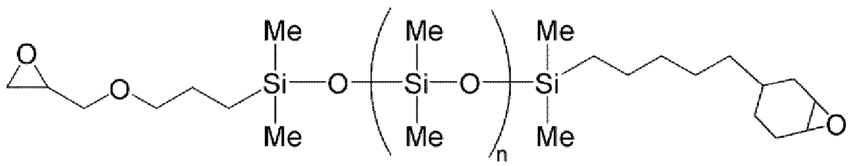 | ※ n=40 |
| x | 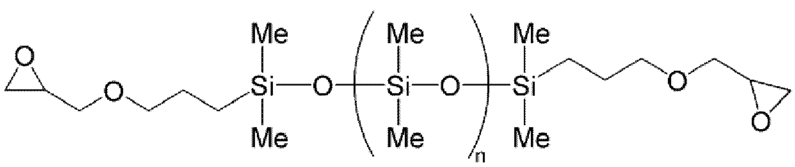 | ※ n=44 |

For each compound in Tables 4-3 and 4-4, the sequence of the structures in the m-subscripted parentheses is random and the sequence of the structures in the n-subscripted parentheses is random.

[Table 4-4]

| No. | Compound | |
|---|---|---|
| y | 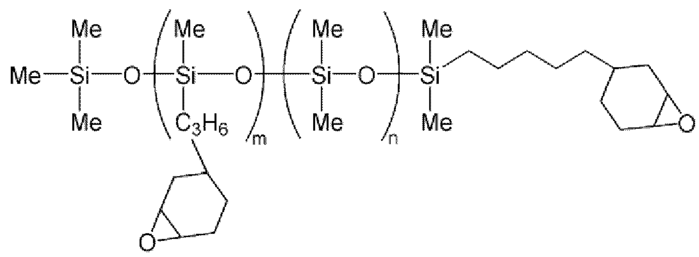 | ※ m=1<br>n=30 |

(continued)

| No. | Compound | |
|---|---|---|
| z | 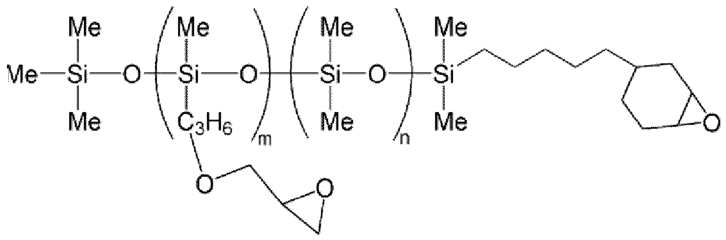 | ※ m=1<br>n-30 |
| A | 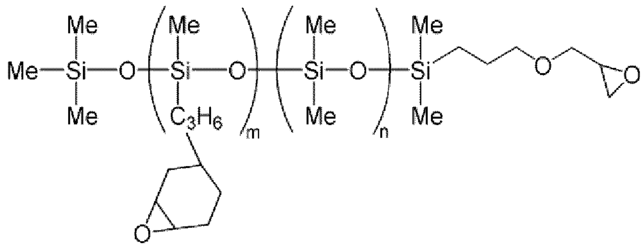 | m=1<br>※ n=30 |
| B | 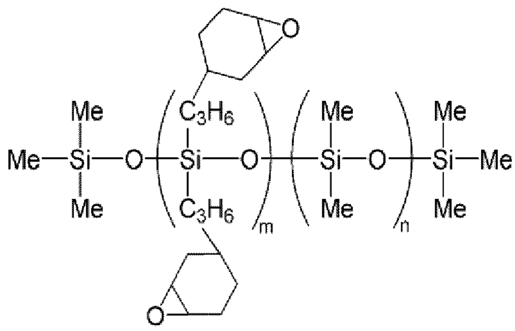 | ※ m=1<br>n=30 |
| C | 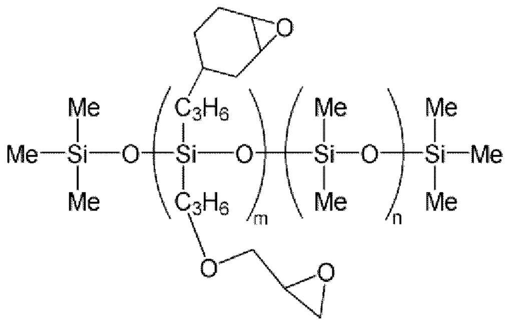 | ※ m=1.<br>n=30 |
| D | 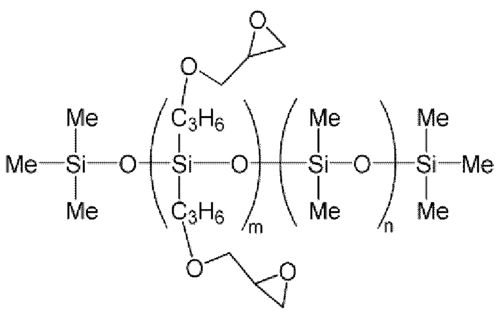 | ※ m=1<br>n=30 |

[Table 5-1]

| Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | A:B molar ratio | Initial | After immersion in ink | After wiping test |
| 1 | 1 | | | - | | | 3:1 | A | A | B |
| 2 | 2 | | | - | | | 1:1 | A | A | A |
| 3 | 3 | a | | - | | | 1:3 | A | B | A |
| 4 | 4 | | | m | | | 1:1 | A | B | A |
| 5 | 5 | | e | n | | | 1:1 | A | B | A |
| 6 | 6 | | | o | | | 1:1 | A | B | A |
| 7 | 7 | b | | - | | | 1:1 | A | A | A |
| 8 | 8 | c | | - | | | 1:1 | B | B | B |
| 9 | 9 | d | | - | | | 1:1 | A | A | A |
| 10 | 10 | | f | - | | | 1:1 | A | B | B |
| 11 | 11 | | 9 | - | | | 1:1 | A | B | B |
| 12 | 12 | | h | - | | | 1:1 | A | A | A |
| 13 | 13 | a | i | - | | | 1:1 | B | B | B |
| 14 | 14 | | j | - | | v | 1:1 | A | B | B |
| 15 | 15 | | k | - | | | 1:1 | A | B | B |
| 16 | 16 | | l | - | | | 1:1 | A | B | B |
| 17 | 17 | | m | - | | | 1:1 | B | B | B |
| 18 | 18 | | f | - | | | 1:1 | A | B | B |
| 19 | 19 | | 9 | - | | | 1:1 | A | B | B |
| 20 | 20 | | h | - | | | 1:1 | A | A | A |
| 21 | 21 | d | i | - | | | 1:1 | B | B | B |
| 22 | 22 | | j | - | | | 1:1 | A | B | B |
| 23 | 23 | | k | - | p | | 1:1 | A | B | B |
| 24 | 24 | | l | - | | | 1:1 | A | B | B |
| 25 | 25 | | m | - | | | 1:1 | B | B | B |
| 26 | 26 | - | | - | | | 3:1 | A | A | B |
| 27 | 27 | - | | - | | | 1:1 | A | A | A |
| 28 | 28 | - | | - | | | 1:3 | A | B | A |
| 29 | 29 | - | | - | | | 3:1 | A | A | B |
| 30 | 30 | - | | - | | w | 1:1 | A | A | B |
| 31 | 31 | - | | - | | | 1:3 | A | B | B |
| 32 | 32 | - | | - | | | 3:1 | A | A | B |
| 33 | 33 | - | | - | | x | 1:1 | A | A | B |
| 34 | 34 | - | | - | | | 1:3 | A | A | B |
| 35 | 35 | - | e | - | | | 3:1 | A | A | A |
| 36 | 36 | - | | - | | y | 1:1 | A | A | A |
| 37 | 37 | - | | - | | | 1:3 | A | B | A |

(continued)

| Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | A:B molar ratio | Initial | After immersion in ink | After wiping test |
| 38 | 38 | - | | - | | z | 3:1 | A | A | B |
| 39 | 39 | - | | - | | | 1:1 | A | A | B |
| 40 | 40 | - | | - | | | 1:3 | A | B | B |
| 41 | 41 | - | | - | | A | 3:1 | A | A | B |
| 42 | 42 | - | | - | | | 1:1 | A | A | B |
| 43 | 43 | - | | - | | | 1:3 | A | B | B |
| 44 | 44 | - | | - | | B | 3:1 | A | A | A |
| 45 | 45 | - | | - | | | 1:1 | A | A | A |

[Table 5-2]

| Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | A:B molar ratio | Initial | After immersion in ink | After wiping test |
| 46 | 46 | - | e | - | p | B | 1:3 | A | B | A |
| 47 | 47 | - | | - | | C | 3:1 | A | A | B |
| 48 | 48 | - | | - | | | 1:1 | A | A | B |
| 49 | 49 | - | | - | | C | 1:3 | A | B | B |
| 50 | 50 | - | | - | | D | 3:1 | A | A | B |
| 51 | 51 | - | | - | | | 1:1 | A | A | B |
| 52 | 52 | - | | - | | | 1:3 | A | A | B |
| 53 | 53 | - | | - | q | v | 1:1 | B | B | A |
| 54 | 54 | - | | - | r | | 1:1 | A | B | A |
| 55 | 55 | - | | - | s | | 3:1 | A | A | B |
| 56 | 56 | - | | - | | | 1:1 | A | A | B |
| 57 | 57 | - | | - | | | 1:3 | A | B | A |
| 58 | 58 | - | | - | | w | 3:1 | A | A | B |
| 59 | 59 | - | | - | | | 1:1 | A | B | B |
| 60 | 60 | - | | - | | | 1:3 | A | B | A |
| 61 | 61 | - | | - | | x | 3:1 | A | A | B |
| 62 | 62 | - | | - | | | 1:1 | A | A | B |
| 63 | 63 | - | | - | | | 1:3 | A | B | B |
| 64 | 64 | - | | - | | y | 3:1 | A | A | B |
| 65 | 65 | - | | - | | | 1:1 | A | A | B |
| 66 | 66 | - | | - | | | 1:3 | A | B | A |
| 67 | 67 | - | | - | | z | 3:1 | A | A | B |
| 68 | 68 | - | | - | | | 1:1 | A | B | B |
| 69 | 69 | - | | - | | | 1:3 | A | B | A |

(continued)

| Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | A:B molar ratio | Initial | After immersion in ink | After wiping test |
| 70 | 70 | - | | - | | A | 3:1 | A | A | B |
| 71 | 71 | - | | - | | | 1:1 | A | B | B |
| 72 | 72 | - | | - | | | 1:3 | A | B | A |
| 73 | 73 | - | | - | | B | 3:1 | A | A | B |
| 74 | 74 | - | | - | | | 1:1 | A | A | B |
| 75 | 75 | - | | - | | | 1:3 | A | B | A |
| 76 | 76 | - | | - | | C | 3:1 | A | A | B |
| 77 | 77 | - | | - | | | 1:1 | A | B | B |
| 78 | 78 | - | | - | | | 1:3 | A | B | A |
| 79 | 79 | - | | - | | D | 3:1 | A | A | B |
| 80 | 80 | - | | - | | | 1:1 | A | A | B |
| 81 | 81 | - | | - | | | 1:3 | A | B | B |
| 82 | 82 | - | | - | t | v | 3:1 | A | A | B |
| 83 | 83 | - | | - | | | 1:1 | A | A | A |
| 84 | 84 | - | | - | | | 1:3 | A | B | A |
| 85 | 85 | - | | - | | w | 3:1 | A | A | B |
| 86 | 86 | - | | - | | | 1:1 | A | A | B |
| 87 | 87 | - | | - | | | 1:3 | A | B | B |
| 88 | 88 | - | | - | | x | 3:1 | A | A | B |

[Table 5-3]

| Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | A:B molar ratio | Initial | After immersion in ink | After wiping test |
| 89 | 89 | - | | - | t | x | 1:1 | A | A | B |
| 90 | 90 | - | | - | | | 1:3 | A | A | B |
| 91 | 91 | - | | - | | y | 3:1 | A | A | A |
| 92 | 92 | - | | - | | | 1:1 | A | A | A |
| 93 | 93 | - | | - | | y | 1:3 | A | B | A |
| 94 | 94 | - | | - | | z | 3:1 | A | A | B |
| 95 | 95 | - | | - | | | 1:1 | A | A | B |
| 96 | 96 | - | | - | | | 1:3 | A | B | B |
| 97 | 97 | - | | - | | A | 3:1 | A | A | B |
| 98 | 98 | - | | - | | | 1:1 | A | A | B |
| 99 | 99 | - | | - | | | 1:3 | A | B | B |

(continued)

| Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | A:B molar ratio | Initial | After immersion in ink | After wiping test |
| 100 | 100 | - | e | - | | B | 3:1 | A | A | A |
| 101 | 101 | - | | - | | | 1:1 | A | A | A |
| 102 | 102 | - | | - | | | 1:3 | A | B | A |
| 103 | 103 | - | | - | | C | 3:1 | A | A | B |
| 104 | 104 | - | | - | | | 1:1 | A | A | B |
| 105 | 105 | - | | - | | | 1:3 | A | B | B |
| 106 | 106 | - | | - | | D | 3:1 | A | A | B |
| 107 | 107 | - | | - | | | 1:1 | A | A | B |
| 108 | 108 | - | | - | | | 1:3 | A | A | B |
| 109 | 109 | - | | - | u | v | 3:1 | A | A | B |
| 110 | 110 | - | | - | | | 1:1 | A | A | B |
| 111 | 111 | - | | - | | | 1:3 | A | B | A |
| 112 | 112 | - | | - | | w | 3:1 | A | A | B |
| 113 | 113 | - | | - | | | 1:1 | A | B | B |
| 114 | 114 | - | | - | | | 1:3 | A | B | A |
| 115 | 115 | - | | - | | x | 3:1 | A | A | B |
| 116 | 116 | - | | - | | | 1:1 | A | A | B |
| 117 | 117 | - | | - | | | 1:3 | A | B | B |
| 118 | 118 | - | | - | | y | 3:1 | A | A | B |
| 119 | 119 | - | | - | | | 1:1 | A | A | B |
| 120 | 120 | - | | - | | | 1:3 | A | B | A |
| 121 | 121 | - | | - | | z | 3:1 | A | A | B |
| 122 | 122 | - | | - | | | 1:1 | A | B | B |
| 123 | 123 | - | | - | | | 1:3 | A | B | A |
| 124 | 124 | - | | - | | A B | 3:1 | A | A | 8 |
| 125 | 125 | - | | - | | | 1:1 | A | B | B |
| 126 | 126 | - | | - | | | 1:3 | A | B | A |
| 127 | 127 | - | | - | | | 3:1 | A | A | B |
| 128 | 128 | - | | - | | | **1:1** | A | A | B |
| 129 | 129 | - | | - | | | 1:3 | A | B | A |
| 130 | 130 | - | | - | | C | 3:1 | A | A | B |
| 131 | 131 | - | | - | | | 1:1 | A | B | B |
| 132 | 132 | - | e | - | u | C | 1:3 | A | B | A |
| 133 | 133 | - | | - | | D | 3:1 | A | A | B |
| 134 | 134 | - | | - | | | 1:1 | A | A | B |
| 135 | 135 | - | | - | | | 1:3 | A | B | B |

[Table 6]

| Comparative Example | Photosensitive resin composition | | | | | | | Water repellency | | |
|---|---|---|---|---|---|---|---|---|---|---|
| | No. | Epoxy resin | Photopolymerization initiator | Cure accelerator | Resin (A) | Resin (B) | AB molar ratio | Initial | After immersion in ink | After wiping test |
| 1 | 136 | - | e | - | p | v | 4:1 | A | A | C |
| 2 | 137 | | | - | p | v | 1:4 | A | C | A |
| 3 | 138 | a | | - | p | - | - | A | A | C |
| 4 | 139 | | | - | - | v | - | A | C | A |
| 5 | 140 | | | - | p | v | 4:1 | A | A | C |
| 6 | 141 | | | - | p | v | 1:4 | A | C | A |
| 7 | 142 | d | | - | p | v | 4:1 | A | A | C |
| 8 | 143 | | | - | p | v | 1:4 | A | C | A |

The appearance of an excellent initial water repellency, an excellent ink durability, and an excellent wiping durability could be realized in Examples 1 to 135 as shown in Tables 5-1, 5-2and 5-3. In particular, an excellent ink durability and an excellent wiping durability were shown by the combination of the resin composition p with the resin composition v. It is thought that, having three of the highly reactive 2-(3,4-epoxycyclohexyl)alkyl groups, a thorough cure occurs.

On the other hand, in Comparative Examples 1 to 8, the mechanical strength was inadequate when $\theta\gamma$ was 70° or less after ink immersion or after wiping. In the case, for example, of the use of only resin (A), it is thought that, for a siloxane resin that comprises one epoxy group, the water-repellent group readily segregates to the surface and the ink durability is thus excellent, while the cure is inadequate and the wiping durability is then inferior.

In the case, on the other hand, of the use of only resin (B), it is thought that a siloxane resin comprising two or more epoxy groups provides an excellent wiping durability, while the liquid repellency is inadequate and the resin is degraded by the ink.

With regard to Comparative Examples 1, 2, 5, 6, 7, and 8 where A : B was outside 3 : 1 to 1 : 3, the ink durability or wiping durability was also reduced.

In the evaluations using inkjet recording heads, there was no distortion even during continuous printing in Examples 1 to 135 and a high print quality was exhibited. In Comparative Examples 1 to 8, on the other hand, distortion was seen after the continuous printing.

As described above, fluorine-based water repellent materials, while exhibiting good water repellencies, raise concerns about their impact on the environment. The photosensitive resin composition according to the present embodiment, on the other hand, exhibits good water repellency even without the incorporation of a fluorine-based water repellent material. The technology described in this Specification can therefore contribute to the realization of a sustainable society, e.g., a decarbonized/recycling society.

Various embodiments have been described in detail above but it will be understood that the present disclosure is not limited to these embodiments and encompasses all modifications, variants, alternatives and equivalents falling within the scope of the appended claims.

## Claims

**1.** An inkjet recording head that has a liquid-repellent anti-fouling film (7) on a surface in which a discharge port (5) is disposed, wherein

the liquid-repellent anti-fouling film (7) is a cured product of a photosensitive resin composition, and
the photosensitive resin composition comprises:

an alkylsiloxane-comprising resin (A) represented by following formula (1);
an alkylsiloxane-comprising resin (B) represented by following formula (2); and
a photopolymerization initiator,
wherein a molar ratio A : B between the alkylsiloxane-comprising resin (A) and the alkylsiloxane-comprising resin (B) is from 3 : 1 to 1 : 3,

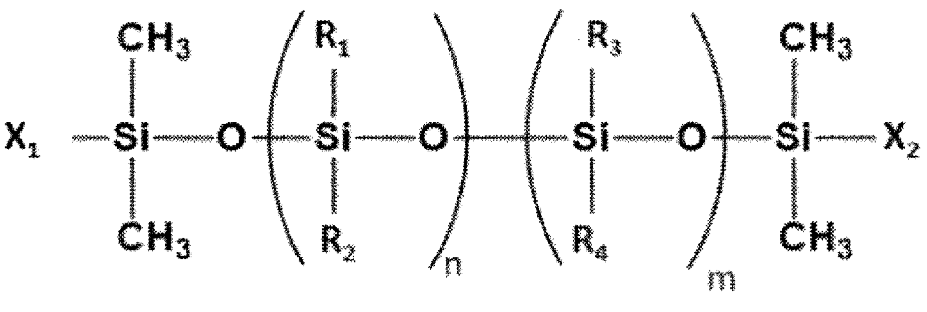

(1)

where, in formula (1), $R_1$, $R_2$, $R_3$, and $X_2$ are each independently an alkyl group with carbon numbers of 1 to 12 or an aryl group with carbon numbers of 6 to 12; one of either of $R_4$ and $X_1$ is an alkyl group with carbon numbers of 1 to 12 or an aryl group with carbon numbers of 6 to 12 and other one is an epoxy-comprising group; and n + m is an integer from 1 to 60; a sequence of a structure of parentheses marked with m and a sequence of a structure of parentheses marked with n may be random or block,

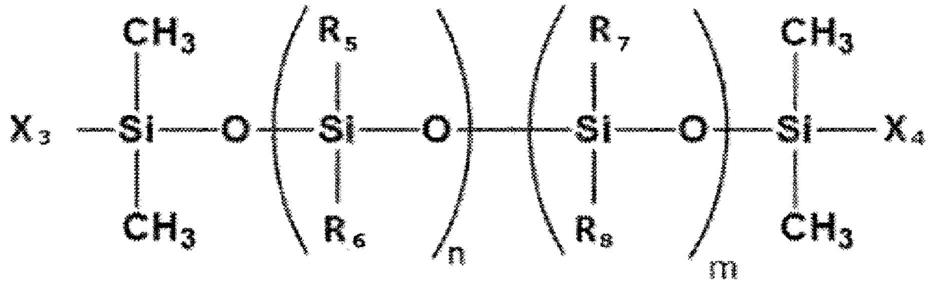

(2)

in formula (2), $R_5$ and $R_6$ are each independently an alkyl group with carbon numbers of 1 to 12 or an aryl group with carbon numbers of 6 to 12; at least two of $R_7$, $R_8$, $X_3$ and $X_4$ are each independently an epoxy-comprising group, and others are each independently an alkyl group with carbon numbers of 1 to 12 or an aryl group with carbon numbers of 6 to 12; and n + m is an integer from 1 to 60; and a sequence of a structure of parentheses marked with m and a sequence of a structure of parentheses marked with n may be random or block.

**2.** The inkjet recording head according to claim 1, wherein the $X_1$ in the formula (1) is the epoxy-comprising group.

**3.** The inkjet recording head according to claim 1 or 2, wherein

the $X_3$ and the $X_4$ in the formula (2) are epoxy-comprising groups, and
the $R_7$ and the $R_8$ are each independently an alkyl group with carbon numbers of 1 to 12 or an aryl group with carbon numbers of 6 to 12.

**4.** The inkjet recording head according to any one of claims 1 to 3, wherein the epoxy-comprising group is a group having glycidyl ether group or a group having epoxycyclohexyl group.

**5.** The inkjet recording head according to any one of claims 1 to 4, wherein the epoxy-comprising group is a glycidoxyalkyl group having an alkyl chain with carbon numbers of 1 to 4 or an epoxycyclohexylalkyl group having an alkyl chain with carbon numbers of 1 to 8.

**6.** The inkjet recording head according to any one of claims 1 to 5, wherein the photopolymerization initiator is cationically polymerizable.

**7.** The inkjet recording head according to any one of claims 1 to 6, wherein the photopolymerization initiator is an ionic acid generator and a cation in the ionic acid generator is a sulfonium ion.

**8.** The inkjet recording head according to any one of claims 1 to 7, wherein a molar extinction coefficient of the photopolymerization initiator at a wavelength of 365 nm is 400 $M^{-1} \cdot cm^{-1}$ or more.

**9.** The inkjet recording head according to any one of claims 1 to 8, wherein

the photopolymerization initiator is an ionic acid generator, and
an anion in the ionic acid generator is at least one selected from the group consisting of tetrakis(pentafluorophenyl)borate ion, trifluorotris(pentafluoroethyl)phosphate ion, hexafluoroantimonate ion, and tetrakis(pentafluorophenyl)gallate ion.

**10.** The inkjet recording head according to any one of claims 1 to 9, wherein the photosensitive resin composition comprises an epoxy resin.

**11.** The inkjet recording head according to claim 10, wherein the epoxy resin is at least one selected from the group consisting of epoxy resin having an alicyclic skeleton, epoxy resin having a bisphenol skeleton, epoxy resin having a phenol novolac skeleton, epoxy resin having a cresol novolac skeleton, epoxy resin having a norbornene skeleton, epoxy resin having a terpene skeleton, epoxy resin having a dicyclopentadiene skeleton, and epoxy resin having an oxycyclohexane skeleton.

**12.** The inkjet recording head according to any one of claims 1 to 11, wherein the photosensitive resin composition

comprises a phenolic compound or a polyol having at least 2 hydroxyl groups as a cure accelerator.

Fig. 1A

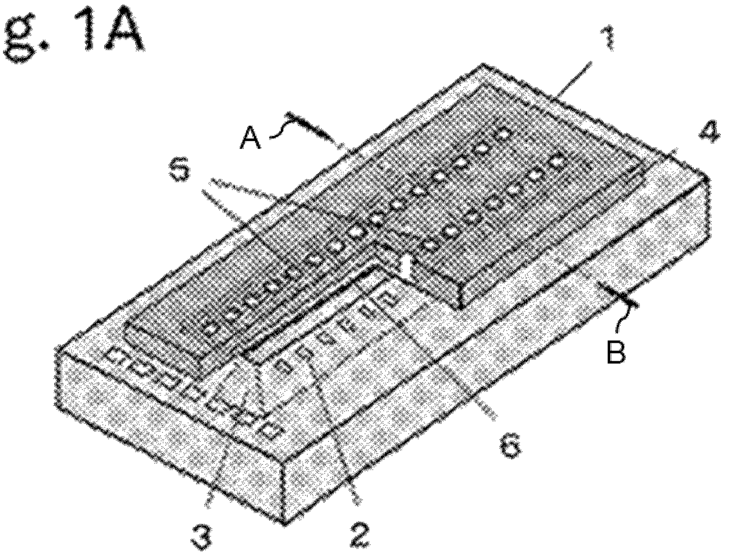


Fig. 1B

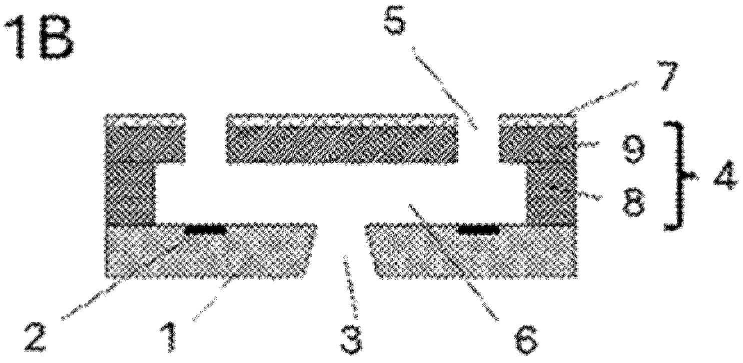

Fig. 2A

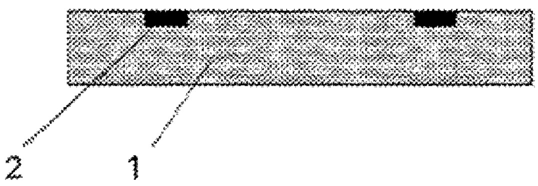


Fig. 2B

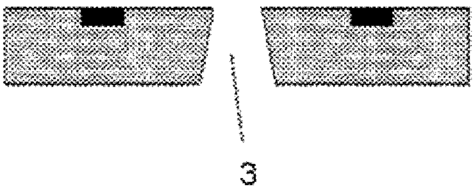


Fig. 2C

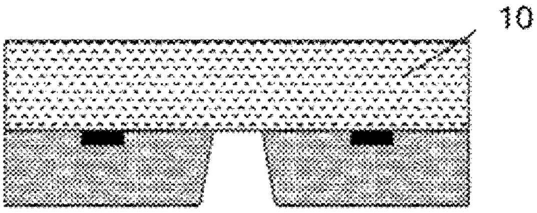


Fig. 2D

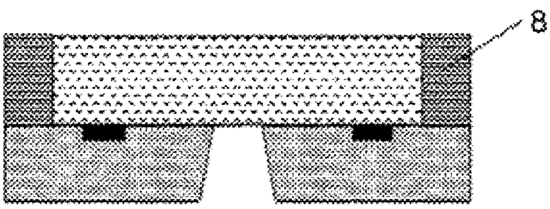


Fig. 2E

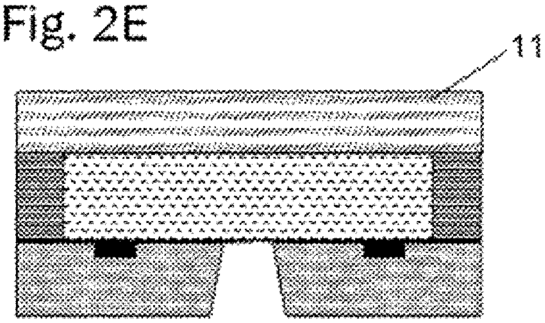


Fig. 2F

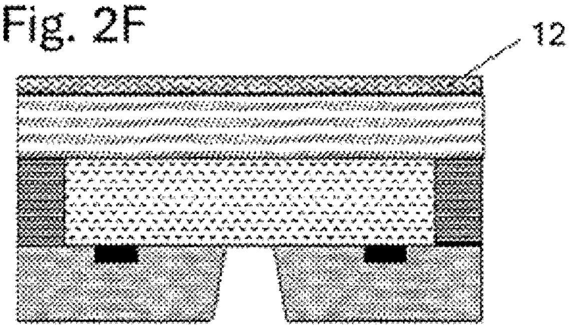


Fig. 2G

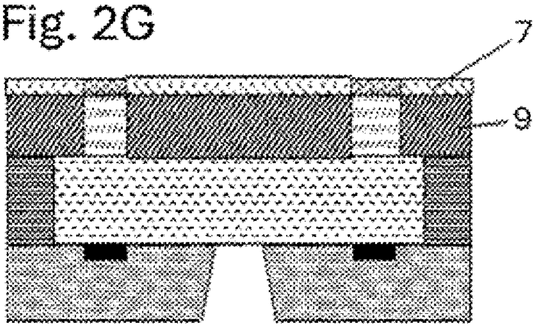


Fig. 2H

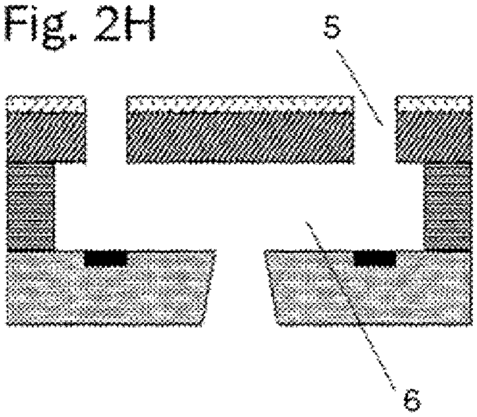

Fig. 3A

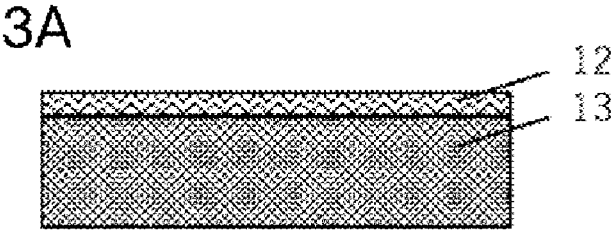


Fig. 3B

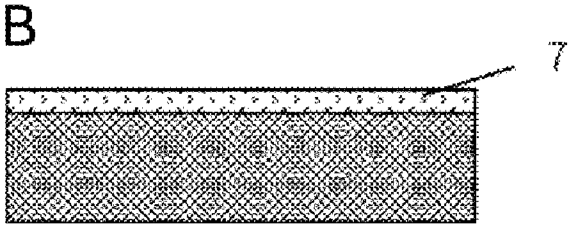

Europäisches Patentamt
European Patent Office
Office européen des brevets

# EUROPEAN SEARCH REPORT

Application Number
EP 25 19 3968

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2003/170401 A1 (SHIMOMURA AKIHIKO [JP] ET AL) 11 September 2003 (2003-09-11) * paragraph [0040] - paragraph [0083] * | 1-12 | INV. B41J2/16 |
| A | US 2010/165044 A1 (PARK SUNG-JOON [KR] ET AL) 1 July 2010 (2010-07-01) * paragraph [0034] - paragraph [0037]; claims 1,2,8 * | 1-12 | |
| A | JP 4 838056 B2 (RICOH KK) 14 December 2011 (2011-12-14) * paragraph [0050] - paragraph [0052] * | 1-12 | |
| A | JP 2014 196002 A (CANON KK) 16 October 2014 (2014-10-16) * claim 1 * | 1-12 | |
| | | | TECHNICAL FIELDS SEARCHED (IPC) |
| | | | B41J |

The present search report has been drawn up for all claims

1

| Place of search | Date of completion of the search | Examiner |
|---|---|---|
| The Hague | 24 November 2025 | Curt, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 19 3968

This annex lists the patent family members relating to the patent documents cited in the above-mentioned European search report. The members are as contained in the European Patent Office EDP file on
The European Patent Office is in no way liable for these particulars which are merely given for the purpose of information.

24-11-2025

| Patent document cited in search report | Publication date | Patent family member(s) | Publication date |
|---|---|---|---|
| US 2003170401 A1 | 11-09-2003 | AT E305947 T1 | 15-10-2005 |
| | | CN 1432600 A | 30-07-2003 |
| | | DE 60301736 T2 | 06-07-2006 |
| | | EP 1329472 A1 | 23-07-2003 |
| | | KR 20030063164 A | 28-07-2003 |
| | | US 2003170401 A1 | 11-09-2003 |
| | | US 2006089466 A1 | 27-04-2006 |
| US 2010165044 A1 | 01-07-2010 | KR 20100080096 A | 08-07-2010 |
| | | US 2010165044 A1 | 01-07-2010 |
| JP 4838056 B2 | 14-12-2011 | JP 4838056 B2 | 14-12-2011 |
| | | JP 2007331127 A | 27-12-2007 |
| JP 2014196002 A | 16-10-2014 | JP 5859070 B2 | 10-02-2016 |
| | | JP 2014196002 A | 16-10-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001158818 A